# EUROPÄISCHE PATENTSCHRIFT

(11) **EP 2 917 080 B1**
(45) Veröffentlichungstag und Bekanntmachung des Hinweises auf die Patenterteilung: **15.03.2017**
(21) Anmeldenummer: 13783917.1
(22) Anmeldetag: 29.10.2013
(51) Int. Cl.: B60T 8/36, H01R 13/04, H01R 13/10, H01R 13/207

(54) **ELEKTROHYDRAULISCHES BZW. ELEKTROMECHANISCHES KRAFTFAHRZEUGSTEUERGERÄT**
ELECTROHYDRAULIC AND/OR ELECTROMECHANICAL MOTOR VEHICLE CONTROL DEVICE
APPAREIL DE COMMANDE ÉLECTROHYDRAULIQUE ET/OU ÉLECTROMÉCANIQUE POUR VÉHICULE AUTOMOBILE

(30) Priorität: 09.11.2012 DE 102012220485
(43) Veröffentlichungstag der Anmeldung: 16.09.2015
(73) Patentinhaber: Continental Teves AG&Co. Ohg, 60488 Frankfurt (DE)
(72) Erfinder: HEISE, Andreas, 64390 Erzhausen (DE)
(86) Internationale Anmeldenummer: PCT/EP2013/072621
(87) Internationale Veröffentlichungsnummer: WO 2014/072207

(56) Entgegenhaltungen:
- WO-A1-2006/067070
- US-B1- 6 241 489

## Beschreibung

Die vorliegende Erfindung betrifft ein elektrohydraulisches und/oder ein elektromechanisches Kraftfahrzeugsteuergerät gemäß Oberbegriff von Anspruch 1.

Bei elektrohydraulischen Kraftfahrzeugsteuergeräten, wie beispielsweise Druckregelvorrichtungen (HECU) für Bremssysteme, hat sich eine Anordnung durchgesetzt, welche aus einer elektronischen Kontrolleinheit an der einen Seite, einer Hydraulikeinheit in der Mitte und einer Elektromotoreinheit für eine hydraulische Pumpe an der gegenüberliegenden Seite der Druckregelvorrichtung besteht. Die Elektromotoreinheit wird durch die Kontrolleinheit mit Hilfe eines an sich bekannten Pumpenmotoradapters kontaktiert. Elektromechanische, wie zum Beispiel Getriebesteuergeräte, als auch elektrohydraulische Steuergeräte weisen häufig einen leitfähigen, insbesondere metallischen Gehäuseteil und einen ein- oder mehrteiligen Gehäuseteil aus Kunststoff auf. Beide Gehäuseteile gemeinsam bilden dabei häufig auch die Außenbegrenzung der Steuergeräte.

Im Betrieb können Potentialunterschiede zwischen dem aus einem elektrisch leitfähigen Vollmaterial bestehenden Grundkörper der Hydraulikeinheit und/oder dem elektrisch leitfähigen Gehäuseteil und der elektronischen Kontrolleinheit zu Störungen, Beschädigungen oder Zerstörung empfindlicher elektronischer Bauelemente führen und somit die Verfügbarkeit des jeweiligen zu steuernden Systems und die Sicherheit von Personen beeinträchtigen. Daher werden erhebliche Anforderungen besonders an die elektromagnetische Verträglichkeit und hinsichtlich des Schutzes gegen elektrostatische Entladung gestellt. An sich bekannt ist das Herstellen einer elektrischen Verbindung zwischen unterschiedlichen leitfähigen Komponenten, um einen Potentialausgleich herzustellen.

Für elektrische Kontaktierungen in Kraftfahrzeugsteuergeräten steht neben einer robusten Ausführung auch ein geringer baulicher sowie funktioneller Mitteleinsatz im Fokus. Unter Robustheit sind dabei beispielsweise Vibrationsfestigkeit, Korrosions-, Temperatur- und Alterungsbeständigkeit zu verstehen.

Für ein von der Karosserie als Bezugspotential über einen gedichteten Kontaktstecker in das Gehäuse der elektronischen Kontrolleinheit geführtes, isoliertes Masseband oder eine Leitung ist die Abdichtung an der Eintrittsstelle ins Gehäuse problematisch, da durch Kapillarwirkung des isolierten Litze-Massebandes Wasser durch den abgedichteten Kontaktstecker ins Gehäuse eindringen und den Kontaktstecker sowie weitere Komponenten zerstören kann.

Die zum Zeitpunkt der vorliegenden Anmeldung nicht veröffentlichte ältere Anmeldung DE 102 012 219 579 beschreibt eine Anbindung eines Bezugspotentials eines Fahrzeugs über eine Hydraulikeinheit, wobei zwischen der Hydraulikeinheit und einer Leiterplatte ein Verbindungskontakt vorgesehen ist, worüber eine Hauptstromanbindung des Bezugspotentials einer elektronischen Kontrolleinheit realisiert ist.

Die zum Zeitpunkt der vorliegenden Anmeldung nicht veröffentlichte ältere Anmeldung EP 12 464 013 beschreibt eine elektrohydraulische Druckregelvorrichtung für Kraftfahrzeugbremssysteme, welche einen elektrisch leitfähigen Verbindungskontakt zwischen einer Hydraulikeinheit und einer elektronischen Kontrolleinheit aufweist, welcher elastische oder federnde Mittel entlang der Längsachse umfasst. Aufgrund der hohen Stückzahlen, mit welchen Kraftfahrzeugsteuergeräte produziert werden, besteht ein enormer Kostendruck auf sämtliche Komponenten. Insbesondere das Einsparen von Material sowie Prozessschritten bei der Herstellung sind hierbei preistreibende Faktoren. Des Weiteren besteht die Notwendigkeit, den Platzbedarf und das Gewicht bereits existierender Systeme weiter zu verringern und dabei dennoch die Verfügbarkeit zumindest zu erhalten oder zu verbessern.

Aus der WO 2006/067070 A ist ein elektrohydraulisches Kraftfahrzeugsteuergerät für ein Kraftfahrzeugbremssystem bekannt, welches eine Hydraulikeinheit und eine mit der Hydraulikeinheit verbundene elektronische Kontrolleinheit umfasst, wobei die Kontrolleinheit eine Leiterplatte zur Aufnahme von elektrischen und elektronischen Bauteilen sowie einen Anschlussstecker umfasst.

Die Aufgabe der Erfindung besteht nun darin, ein elektrohydraulisches und/oder ein elektromechanisches Kraftfahrzeugsteuergerät zur Verfügung zu stellen, welche den Anforderungen moderner und zukünftiger Steuergeräte besser gewachsen ist. Diese Aufgabe wird gelöst durch ein elektrohydraulisches und/oder elektromechanisches Kraftfahrzeugsteuergerät gemäß Anspruch 1.

Die Erfindung beschreibt ein elektrohydraulisches und/oder elektromechanisches Kraftfahrzeugsteuergerät, insbesondere für ein Kraftfahrzeugbremssystem, umfassend eine mit einer Hydraulikeinheit und/oder zumindest einem elektrisch leitfähigen Gehäuseteil des Steuergeräts verbundene elektronische Kontrolleinheit, wobei diese mindestens eine erste Leiterplatte zur Aufnahme von elektrischen und/oder elektronischen Bauteilen sowie mindestens einen Anschlussstecker umfasst, und sich weiterhin dadurch auszeichnet, dass mindestens ein elektrisch leitfähiger Verbindungskontakt vorgesehen ist, welcher mit mindestens einem elektrisch leitfähigen Befestigungsmittel derart verbunden ist, dass eine elektrisch leitfähige Verbindung zwischen einem elektrisch leitfähigen Grundkörper der Hydraulikeinheit und/oder dem Gehäuseteil und dem Bezugspotential der Leiterplatte der elektronischen Kontrolleinheit besteht.

Das Befestigungsmittel ist bevorzugt in einer Ausnehmung des Grundkörpers der Hydraulikeinheit und/oder des Gehäuseteils vorgesehen, wobei das Befestigungsmittel elektrisch leitfähig mit dem Grundkörper der Hydraulikeinheit und/oder dem Gehäuseteil verbunden ist.

Gemäß einer bevorzugten Ausführungsform weist das Befestigungsmittel mindestens ein Einkerbmittel, insbesondere zumindest ein Gewinde, auf, wobei das Einkerbmittel zur Bildung einer elektrischen Verbindung zumindest in den Verbindungskontakt einkerbt.

Weiterhin bevorzugt ist, dass das Einkerbmittel des Befestigungsmittels zur mechanischen Fixierung in zumindest eine Ausformung, insbesondere des Gehäuses der elektronischen Kontrolleinheit, einkerbt.

Das Befestigungsmittel ist bevorzugt als eine selbstfurchende und/oder metrische Schraube umfassend einen Schraubenkopf ausgebildet, wobei der Schraubenkopf auf einer der elektronischen Kontrolleinheit abgewandten Seite auf einem Vorsprung insbesondere in der Ausnehmung des Grundkörpers der Hydraulikeinheit und/oder des Gehäuseteils aufliegt.

Der Verbindungskontakt ist bevorzugt mittels zumindest eines Einpresskontakts mit der Leiterplatte elektrisch leitfähig verbunden.

Gemäß einer weiteren bevorzugten Ausführungsform ist ein Bezugspotentialanschluss zur Bildung einer Hochstromanbindung an dem Grundkörper der Hydraulikeinheit und/oder dem Gehäuseteil vorgesehen, welcher ein Bezugspotential des Kraftfahrzeugs mit dem Grundkörper der Hydraulikeinheit und/oder dem Gehäuseteil verbindet. Beispiele für einen Bezugspotentialanschluss sind ein Masseband oder auch ein metallischer Halter an der Hydraulikeinheit und/oder dem Gehäuseteil, welcher die Hydraulikeinheit und/oder das Gehäuseteil elektrisch leitfähig mit weiteren Fahrzeugkomponenten, insbesondere dem Fahrzeugbezugspotential, verbindet.

Bevorzugt fixiert das Befestigungsmittel mechanisch zumindest eine weitere Komponente, insbesondere zumindest ein Gehäuseelement der Elektromotoreinheit, an dem Grundkörper der Hydraulikeinheit und/oder dem Gehäuseteil.

Weitere bevorzugte Ausführungsformen ergeben sich aus der nachfolgenden Beschreibung von Ausführungsbeispielen an Hand von Figuren.
Es zeigen:
Fig. 1 eine erste Ausführungsform des erfindungsgemäßen elektrohydraulischen und/oder elektromechanischen Kraftfahrzeugsteuergeräts am Beispiel einer elektrohydraulischen Druckregelvorrichtung für Kraftfahrzeugbremssysteme,
Fig. 2 weitere Ausführungsbeispiele von Abdichtungen von Schraubenausnehmung einer elektrohydraulischen Druckregelvorrichtung,
Fig. 3 Ausführungsbeispiel mit Anbindung eines Grundkörpers der Hydraulikeinheit an ein Bezugspotential eines Fahrzeugs mit Abdichtung durch dichte Auflage eines Schraubenkopfes an einem elektrisch leitfähigen Grundkörper einer Hydraulikeinheit und
Fig. 4 Darstellungen zur Veranschaulichung einer durch eine Schraube erzeugten mechanischen und elektrischen Verbindung während der Montage wie auch unterschiedliche Einbaulagen für ein Kontaktelement.

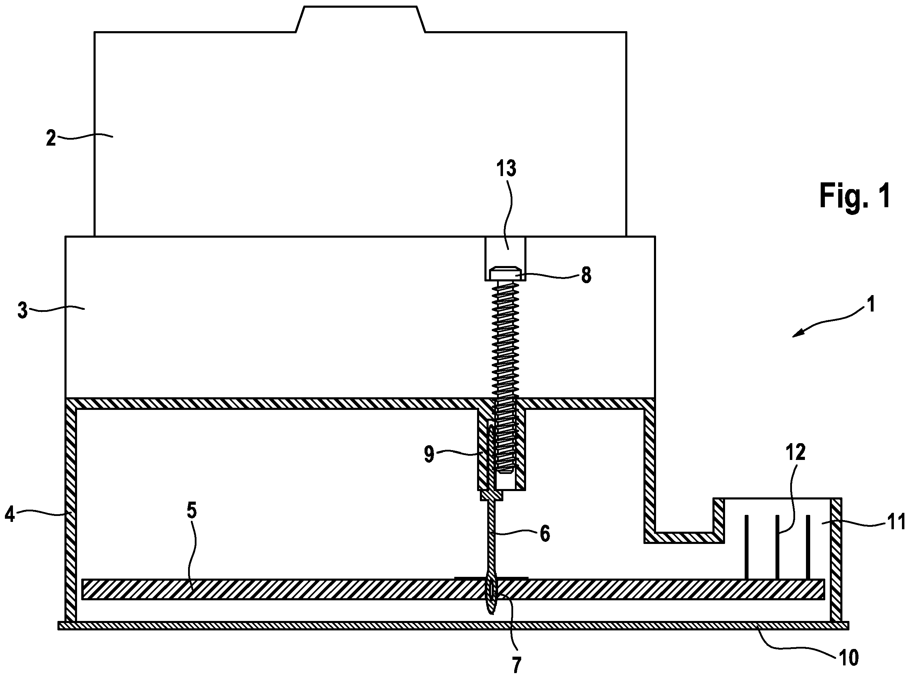

In Fig. 1 ist beispielsgemäß für eine erste Ausführungsform des erfindungsgemäßen elektrohydraulischen und/oder elektromechanischen Kraftfahrzeugsteuergeräts eine marktübliche elektrohydraulische Druckregelvorrichtung 1 (HECU) für ein Kraftfahrzeugbremssystem mit den zusätzlichen, erfindungsgemäßen Merkmalen schematisch dargestellt. Dargestellt sind lediglich die zum Verständnis der vorliegenden Erfindung notwendigsten Komponenten. Die HECU 1 besteht aus drei Einheiten, der Elektromotoreinheit 2, welche der Antrieb der Hydraulikpumpe ist, der Hydraulikeinheit 3 (HCU), in der insbesondere die Ventile zur Steuerung des Kraftfahrzeugbremssystems und die Pumpenmechanik untergebracht sind, und der elektronischen Kontrolleinheit 4 (ECU), mit der die Ansteuerung der Ventile umgesetzt wird.

In Kontrolleinheit 4 befindet sich Leiterplatte 5, auf der die für die Ansteuerung notwendigen elektronischen Bauelemente angeordnet sind. Die Spulen, welche das Schalten der Ventile durchführen, befinden sich ebenso im Gehäuse der elektronischen Kontrolleinheit 4, sind jedoch nicht abgebildet. Abdeckplatte 10 bildet gemäß diesem Ausführungsbeispiel eine separate Komponente des Gehäuses von Kontrolleinheit 4, wobei dieses Gehäuseteil gemäß diesem Ausführungsbeispiel aus einem elektrisch leitfähigen Werkstoff, insbesondere einem Metall, besteht.

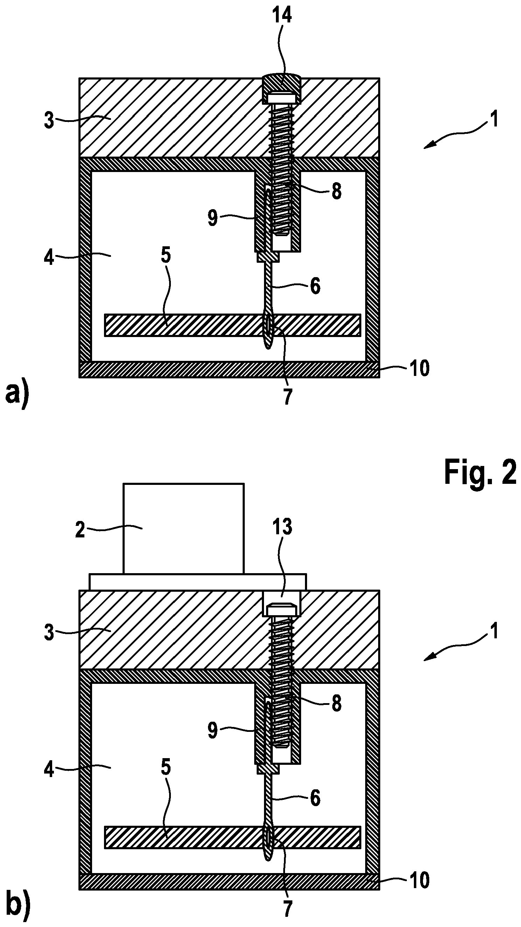

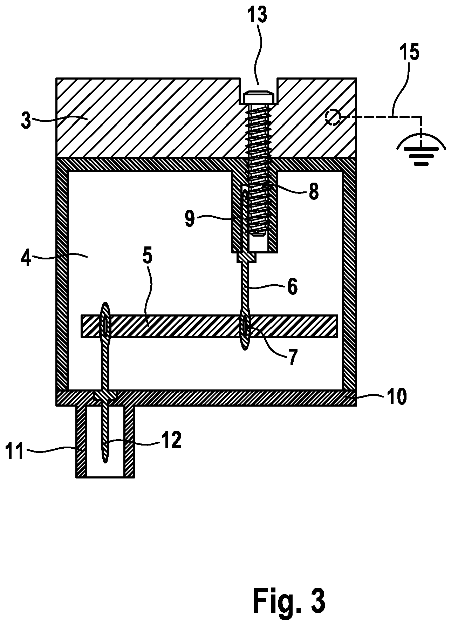

Verbindungskontakt 6 stellt in Kombination mit der von Seiten der Elektromotoreinheit 2 in eine dafür vorgesehene Ausnehmung 13 der Hydraulikeinheit 3 eingeführten Schraube 8 eine elektrisch niederohmig leitende Verbindung zwischen dem elektrisch leitfähigen Grundkörper von Hydraulikeinheit 3 und dem Bezugspotential von Leiterplatte 5 her. Dadurch wird ein gemeinsames Masse- oder Bezugspotential erreicht bzw. können die beiden Masse-Potentiale mit geeigneten elektronischen Bauelementen, wie beispielsweise Kondensatoren bzw. Widerständen, verbunden werden, wodurch die elektromagnetische Verträglichkeit erhöht und der Schutz gegen elektrostatische Entladung verbessert wird. Liegt eine elektrische Anbindung 15 des Grundkörpers der Hydraulikeinheit an das Bezugspotential des Fahrzeugs vor, wie es in Fig. 3 dargestellt ist, kann die Stromversorgung der Druckregelvorrichtung 1 mit Hilfe der Anbindung 15 und mittels Verbindungskontakt 6 und Schraube 8 sowie Verbindung 7 zur Leiterplatte 5 realisiert werden. Eine Abdeckung von Ausnehmung 13 und Abdichtung zum Motorraum erfolgt gemäß dem Ausführungsbeispiel in Fig. 1 und Fig. 2b) durch die Elektromotoreinheit 2 und dessen Dichtflansch, wobei der Dichtflansch als solches nicht dargestellt ist. Schraube 8 kann alternativ zumindest eine weitere Komponente von elektrohydraulischer Druckregelvorrichtung 1, insbesondere jedoch ein Gehäuseelement von Elektromotoreinheit 2, welches den eigentlichen Elektromotor im montierten Zustand im Wesentlichen einfasst, an Hydraulikeinheit 3 mechanisch fixieren. Fig. 2 a) realisiert eine Abdichtung mittels separatem Dichtmittel, insbesondere aus Silikon. In Fig. 3 ist die Dichtung durch den Schraubenkopf durch Pressung des Schraubenkopfes an einen Anpressbereich, insbesondere einem Vorsprung in Schraubenausnehmung 13 des Grundkörpers der Hydraulikeinheit 3 umgesetzt, welches erhöhte Anforderungen an die Schraubenvorspannung stellt. Wird alternativ, wie es für elektromechanische Steuergeräte der Fall sein kann, oder in Ergänzung zur elektrischen Verbindung des Grundkörpers der Hydraulikeinheit 3 mit Leiterplatte 5 eine Schraube zur elektrischen Verbindung eines elektrisch leitfähigen Gehäuseteils, wie beispielsweise von Abdeckplatte 10, mit Leiterplatte 5 vorgesehen, kann der Schraubenkopf bevorzugt auf dem Gehäuseteil aufliegen.

Verbindungskontakt 6 weist zur Verbindung mit Leiterplatte 5 zumindest einen Einpresskontakt 7 auf, wie er in an sich bekannter Weise bei elektronischer Schaltungstechnik verwendet wird. Alternativ kann Verbindungskontakt 6 beispielsweise auch durch Lötung mit Leiterplatte 5 verbunden sein. Werden in Druckregelvorrichtung 1, wie in Fig. 3 an einem Beispiel-Kontaktstift dargestellt, elektrische Nieder- und/oder Hochstrom-Kontaktstifte 12 für den Kontaktstecker 11 verwendet, so kann ein im Wesentlichen ebensolcher Kontaktstift als Verbindungskontakt 6 Verwendung finden.

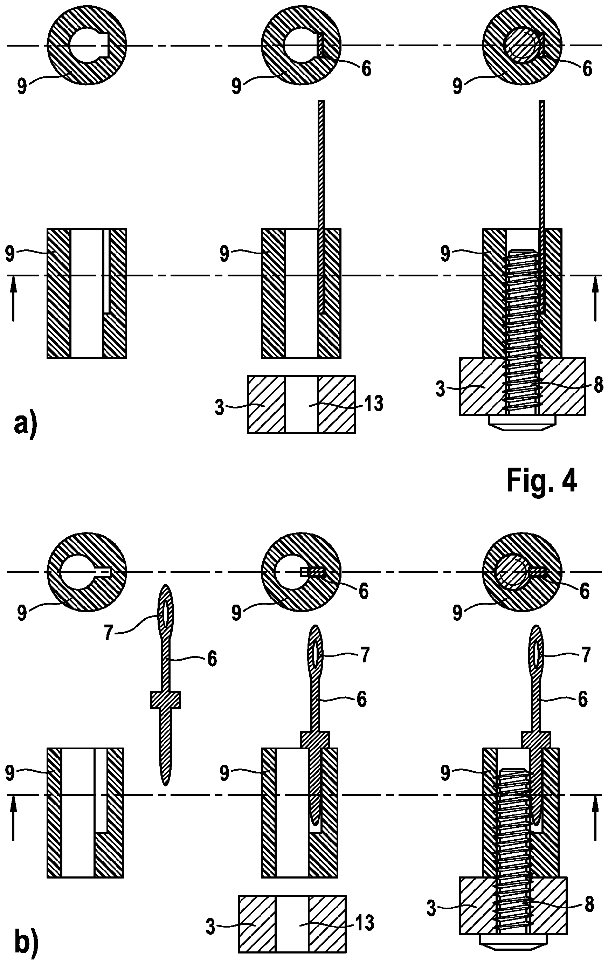

Wie in den Figuren 4 a) und b) dargestellt, kerbt das Gewinde von Schraube 8 während der Montage zumindest in Ausformung 9 des Gehäuses von Kontrolleinheit 4, welches insbesondere aus Kunststoff besteht, sowie in den Werkstoff des Verbindungskontakts 6 ein. Die mechanische Fixierung und Kontaktierung kann so in einem einzigen Prozessschritt erfolgen. Ebenfalls kann ein Einkerben in den Werkstoff des Grundkörpers von Hydraulikeinheit 3 vorgesehen sein, insbesondere um die Kontaktierung oder mechanische Stabilität zu verbessern. Alternativ können vorgefertigte Gewinde im Grundkörper der Hydraulikeinheit 3 und/oder der Ausformung 9 vorgesehen sein. Während der Montage von Druckregelvorrichtung 1 kann vor dem Einschrauben von Schraube 8 Verbindungskontakt 6 in Ausformung 9 ragen, in diesen eingeführt, eingepresst oder eingegossen sein. Spätestens nach dem Einschrauben von Schraube 8 ist Verbindungskontakt 6 dann durch Schraube 8 mechanisch fixiert und elektrisch zum Grundkörper der Hydraulikeinheit 3 kontaktiert. Es können zudem mehrere parallel ausgeführte Anordnungen der erfindungsgemäßen Verbindung von Leiterplatte 5 zum Grundkörper der Hydraulikeinheit 3 vorgesehen sein.

Als Schraubentyp eignen sich insbesondere handelsübliche selbstfurchende Schrauben oder Schrauben mit metrischem Gewinde, welche insbesondere aus Metall gefertigt sind. Der Kopf von Schraube 8 kann beispielsweise durch Formschluss eine Dichtungsfunktion realisieren oder es werden separate Dichtmittel vorgesehen. Verbindungskontakt 6 besteht, wie Einpresskontakt 7, aus handelsüblichen Werkstoffen, wie zum Beispiel CuSN4, CuSN5, CuSN6 oder CuNiSi oder enthält diese zu wesentlichen Teilen. Alternativ zu Schraube 8 können auch Gewindestangen ohne Kopf verwendet werden. Werden jedoch Schrauben ohne Anpressen des Schraubenkopfes verwendet, welche im metallischen Bereich des Grundkörpers der Hydraulikeinheit 3 nicht furchen, so ist eine mechanische Fixierung, als Schutz gegen ein Lösen aufgrund von Vibrationen, zur Stabilisierung der Anordnung am Kunststoffgehäuse vorgesehen, welche durch den eingelegten Verbindungskontakt 6 verstärkt wird. Zusätzlich können weiter Schraubensicherungs- und/oder Dichtungsmittel 14 vorgesehen sein, welche den Umgebungsbedingungen angepasst sind und ein Lösen von Schraube 8 oder Feuchtigkeitseintritt vermeiden.

Bevorzugt kann eine Oberflächenbeschichtung von Verbindungskontakt 6 bzw. Einpresskontakt 7, beispielsweise durch Verzinkung oder mit Zinn, und/oder Schraube 8, zum Beispiel mit einer Zink-Lammellenbeschichtung oder auch Verkupferung oder Kombinationen aus diesen, vorgesehen sein.

### Bezugszeichenliste

1 Elektrohydraulische Druckregelvorrichtung
2 Elektromotoreinheit
3 Hydraulikeinheit
4 Elektronische Kontrolleinheit
5 Leiterplatte/Schaltungsträger
6 Verbindungskontakt
7 Einpresskontakt
8 Befestigungsmittel/Schraube
9 Ausformung des Gehäuses der Kontrolleinheit 4
10 Abdeckplatte/Deckel
11 Kontaktstecker
12 Kontaktstift
13 Schraubenausnehmung
14Schraubensicherungs- und/oder Dichtungsmittel
15 Elektrische Anbindung an das Bezugspotential des Fahrzeugs

## Patentansprüche

1. Elektrohydraulisches und/oder elektromechanisches Kraftfahrzeugsteuergerät (1), insbesondere für ein Kraftfahrzeugbremssystem, umfassend eine mit einer Hydraulikeinheit (3) und/oder zumindest einem elektrisch leitfähigen Gehäuseteil des Steuergeräts (1) verbundene elektronische Kontrolleinheit (4), wobei diese mindestens eine erste Leiterplatte (5) zur Aufnahme von elektrischen und/oder elektronischen Bauteilen sowie mindestens einen Anschlussstecker (8) umfasst, **dadurch gekennzeichnet, dass** mindestens ein elektrisch leitfähiger Verbindungskontakt (6) vorgesehen ist, welcher mit mindestens einem elektrisch leitfähigen Befestigungsmittel (8) derart verbunden ist, dass eine elektrisch leitfähige Verbindung zwischen einem elektrisch leitfähigen Grundkörper der Hydraulikeinheit (3) und/oder dem Gehäuseteil und dem Bezugspotential der Leiterplatte (5) der elektronischen Kontrolleinheit (4) besteht.

2. Elektrohydraulisches und/oder elektromechanisches Kraftfahrzeugsteuergerät (1) nach Anspruch 1, **dadurch gekennzeichnet, dass** das Befestigungsmittel (8) in einer Ausnehmung (13) des Grundkörpers der Hydraulikeinheit (3) und/oder des Gehäuseteils vorgesehen ist, wobei das Befestigungsmittel (8) elektrisch leitfähig mit dem Grundkörper der Hydraulikeinheit (3) und/oder dem Gehäuseteil verbunden ist.

3. Elektrohydraulisches und/oder elektromechanisches Kraftfahrzeugsteuergerät (1) nach Anspruch 1 oder 2, **dadurch gekennzeichnet, dass** das Befestigungsmittel (8) mindestens ein Einkerbmittel, insbesondere zumindest ein Gewinde, aufweist, wobei das Einkerbmittel zur Bildung einer elektrischen Verbindung zumindest in den Verbindungskontakt (6) einkerbt.

4. Elektrohydraulisches und/oder elektromechanisches Kraftfahrzeugsteuergerät (1) nach Anspruch 3, **dadurch gekennzeichnet, dass** das Einkerbmittel des Befestigungsmittels (8) zur mechanischen Fixierung in zumindest eine Ausformung (9) des Gehäuses der elektronischen Kontrolleinheit (4), einkerbt.

5. Elektrohydraulisches und/oder elektromechanisches Kraftfahrzeugsteuergerät (1) nach mindestens einem der Ansprüche 2 bis 4, **dadurch gekennzeichnet, dass** das Befestigungsmittel (8) als eine selbstfurchende und/oder metrische Schraube (8) umfassend einen Schraubenkopf ausgebildet ist, wobei der Schraubenkopf auf einer der elektronischen Kontrolleinheit (4) abgewandten Seite auf einem Vorsprung in der Ausnehmung (13) des Grundkörpers der Hydraulikeinheit (3) und/oder des Gehäuseteils aufliegt.

6. Elektrohydraulisches und/oder elektromechanisches Kraftfahrzeugsteuergerät (1) nach mindestens einem der Ansprüche 1 bis 5, **dadurch gekennzeichnet, dass** der Verbindungskontakt (6) mittels zumindest eines Einpresskontakts (7) mit der Leiterplatte (5) elektrisch leitfähig verbunden ist.

7. Elektrohydraulisches und/oder elektromechanisches Kraftfahrzeugsteuergerät (1) nach mindestens einem der Ansprüche 1 bis 6, **dadurch gekennzeichnet, dass** ein Bezugspotentialanschluss (15) zur Bildung einer Hochstromanbindung an dem Grundkörper der Hydraulikeinheit (3) und/oder dem Gehäuseteil vorgesehen ist, welcher ein Bezugspotential des Kraftfahrzeugs mit dem Grundkörper der Hydraulikeinheit (3) und/oder dem Gehäuseteil verbindet.

8. Elektrohydraulisches und/oder elektromechanisches Kraftfahrzeugsteuergerät (1) nach mindestens einem der Ansprüche 1 bis 7, **dadurch gekennzeichnet, dass** das Befestigungsmittel (8) zumindest eine weitere Komponente, insbesondere zumindest ein Gehäuseelement einer Elektromotoreinheit (2), an dem Grundkörper der Hydraulikeinheit (3) und/oder dem Gehäuseteil mechanisch fixiert.

## Claims

1. Electrohydraulic and/or electromechanical motor vehicle control device (1), in particular for a motor vehicle brake system, comprising an electronic control unit (4) which is connected to a hydraulic unit (3) and/or at least to an electrically conductive housing part of the control device (1), wherein said electronic control unit comprises at least one first printed circuit board (5) for holding electrical and/or electronic components and also comprises at least one connection plug (8), **characterized in that** at least one electrically conductive connecting contact (6) is provided, said connecting contact being connected to at least one electrically conductive fastening means (8) in such a way that an electrically conductive connection is established between an electrically conductive main body of the hydraulic unit (3) and/or the housing part and the reference potential of the printed circuit board (5) of the electronic control unit (4).

2. Electrohydraulic and/or electromechanical motor vehicle control device (1) according to Claim 1, **characterized in that** the fastening means (8) is provided in a recess (13) in the main body of the hydraulic unit (3) and/or in the housing part, wherein the fastening means (8) is electrically conductively connected to the main body of the hydraulic unit (3) and/or to the housing part.

3. Electrohydraulic and/or electromechanical motor vehicle control device (1) according to Claim 1 or 2, **characterized in that** the fastening means (8) has at least one notching means, in particular at least one thread, wherein the notching means forms a notch at least in the connecting contact (6) in order to form an electrical connection.

4. Electrohydraulic and/or electromechanical motor vehicle control device (1) according to Claim 3, **characterized in that** the notching means of the fastening means (8) forms a notch in at least one shaped portion (9) of the housing of the electronic control unit (4), in order to provide mechanical fixing.

5. Electrohydraulic and/or electromechanical motor vehicle control device (1) according to at least one of Claims 2 to 4, **characterized in that** the fastening means (8) is in the form of a self-tapping and/or metric screw (8) comprising a screw head, wherein the screw head rests on a projection in the recess (13) in the main body of the hydraulic unit (3) and/or in the housing part, on a side which is averted from the electronic control unit (4).

6. Electrohydraulic and/or electromechanical motor vehicle control device (1) according to at least one of Claims 1 to 5, **characterized in that** the connecting contact (6) is electrically conductively connected to the printed circuit board (5) by means of at least one press-in contact (7).

7. Electrohydraulic and/or electromechanical motor vehicle control device (1) according to at least one of Claims 1 to 6, **characterized in that** a reference potential connection (15) for forming a high-current connection to the main body of the hydraulic unit (3) and/or to the housing part is provided, said reference potential connection connecting a reference potential of the motor vehicle to the main body of the hydraulic unit (3) and/or to the housing part.

8. Electrohydraulic and/or electromechanical motor vehicle control device (1) according to at least one of Claims 1 to 7, **characterized in that** the fastening means (8) mechanically fixes at least one further component, in particular at least one housing element of an electric motor unit (2), to the main body of the hydraulic unit (3) and/or to the housing part.

## Revendications

1. Appareil de commande (1) électrohydraulique et/ou électromécanique pour véhicule automobile, en particulier pour un système de freinage de véhicule automobile, comprenant une unité de contrôle électronique (4) qui est reliée à une unité hydraulique (3) et/ou à au moins une partie de boîtier électriquement conductrice de l'appareil de commande (1), laquelle unité de contrôle électronique comprend au moins une première carte de circuit imprimé (5) destinée à recevoir des composants électriques et/ou électroniques ainsi qu'au moins une fiche de connexion (8), **caractérisé en ce qu'**il est prévu au moins un contact de jonction (6) électriquement conducteur qui est relié à au moins un moyen de fixation (8) électriquement conducteur de manière à ce qu'une liaison électriquement conductrice soit établie entre un corps de base électriquement conducteur de l'unité hydraulique (3) et/ou la partie de boîtier et le potentiel de référence de la carte de circuit imprimé (5) de l'unité de contrôle électronique (4).

2. Appareil de commande (1) électrohydraulique et/ou électromécanique pour véhicule automobile selon la revendication 1, **caractérisé en ce que** le moyen de fixation (8) est prévu dans un évidement (13) du corps de base de l'unité hydraulique (3) et/ou de la partie de boîtier, dans lequel le moyen de fixation (8) est relié de manière électriquement conductrice au corps de base de l'unité hydraulique (3) et/ou de la partie de boîtier.

3. Appareil de commande (1) électrohydraulique et/ou électromécanique pour véhicule automobile selon la revendication 1 ou 2, **caractérisé en ce que** le moyen de fixation (8) comporte au moins un moyen d'indentation, notamment au moins un filetage, dans lequel le moyen d'indentation forme au moins une indentation dans le contact de jonction (6) pour former une liaison électrique.

4. Appareil de commande (1) électrohydraulique et/ou électromécanique pour véhicule automobile selon la revendication 3, **caractérisé en ce que** le moyen d'indentation du moyen de fixation (8) forme une indentation pour une fixation mécanique dans au moins un façonnage (9) du boîtier de l'unité de contrôle électronique (4).

5. Appareil de commande (1) électrohydraulique et/ou électromécanique pour véhicule automobile selon au moins l'une des revendications 2 à 4, **caractérisé en ce que** le moyen de fixation (8) est réalisé sous la forme d'une vis (8) autotaraudeuse et/ou métrique comprenant une tête de vis, dans lequel la tête de vis repose sur une face tournée en sens opposé à l'unité de contrôle électronique (4) sur une protubérance formée dans l'évidement (13) du corps de base de l'unité hydraulique (3) et/ou de la partie de boîtier.

6. Appareil de commande (1) électrohydraulique et/ou électromécanique pour véhicule automobile selon au moins l'une des revendications 1 à 5, **caractérisé en ce que** le contact de jonction (6) est relié de manière électriquement conductrice au moyen d'au moins un contact d'insertion (7) à la carte de circuit imprimé (5).

7. Appareil de commande (1) électrohydraulique et/ou électromécanique pour véhicule automobile selon au moins l'une des revendications 1 à 6, **caractérisé en ce qu'**il est prévu, pour former une liaison à courant fort avec le corps de base de l'unité hydraulique (3) et/ou l'élément de boîtier, une borne de potentiel de référence (15) qui relie un potentiel de référence du véhicule automobile au corps de base de l'unité hydraulique (3) et/ou à l'élément de boîtier.

8. Appareil de commande (1) électrohydraulique et/ou électromécanique pour véhicule automobile selon au moins l'une des revendications 1 à 7, **caractérisé en ce que** le moyen de fixation (8) fixe mécaniquement au moins un autre composant, en particulier au moins un élément de boîtier d'une unité à moteur électrique (2), au corps de base de l'unité hydraulique (3) et/ou à la partie de boîtier.
